# EUROPEAN PATENT APPLICATION

(11) **EP 4 318 564 A1**
(43) Date of publication of application: **07.02.2024**
(21) Application number: 21938355.1
(22) Date of filing: 29.04.2021
(51) Int. Cl.: H01L 23/12

(54) **CIRCUIT BOARD ASSEMBLY PART AND ELECTRONIC DEVICE**

(71) Applicant: Huawei Technologies Co., Ltd., Shenzhen, Guangdong 518129 (CN)
(72) Inventor: FENG, Xue, Shenzhen, Guangdong 518129 (CN); WANG, Chen, Shenzhen, Guangdong 518129 (CN)
(74) Representative: Epping - Hermann - Fischer
(86) International application number: PCT/CN2021/090896
(87) International publication number: WO 2022/226873

(57) **Abstract**

This application provides a circuit board assembly and an electronic device. The circuit board assembly includes a chip package structure and a circuit board. The chip package structure is disposed outside the circuit board. The circuit board and the chip package structure each are provided with a connector, and the connector on the circuit board and the connector of the chip package structure may be connected through a wire. A substrate and a chip that are in the chip package structure have close or same coefficients of thermal expansion. Mechanical stability of the circuit board assembly can be improved by using the circuit board assembly provided in embodiments of this application.

## Description

### TECHNICAL FIELD

This application relates to the field of electronic devices and the field of chips, and more specifically, to a circuit board assembly and an electronic device.

### BACKGROUND

An electronic device may include a plurality of chip package structures. By driving and controlling such chip package structures, the electronic device may have functions corresponding to the plurality of chip package structures. The chip package structure may be, for example, disposed on a circuit board. The circuit board may transmit an electrical signal for the chip package structure. When the chip package structure works, the chip package structure may generate heat, and the chip package structure may be slightly deformed. The heat generated by the chip package structure may be further transferred to the circuit board. Because coefficients of thermal expansion of the circuit board and the chip package structure may be different, the circuit board and the chip package structure may have unmatched deformation amounts when being heated or cooled, thereby reducing stability and reliability of a connection between the chip package structure and the circuit board.

### SUMMARY

This application provides a circuit board assembly and an electronic device. The circuit board assembly may include a circuit board and a chip package structure. An objective of this application is to improve mechanical stability and reliability of a circuit board assembly.

According to a first aspect, a circuit board assembly is provided, including:
a first circuit board component, a first chip package structure, and a plurality of first wires, where the first chip package structure is disposed outside the first circuit board component, and the plurality of first wires are configured to transmit a signal between the first circuit board component and the first chip package structure.

The first circuit board component includes:
a first circuit board; and
a first connector, where the first connector is disposed on the first circuit board and is electrically connected to the first circuit board, and the first connector includes a plurality of first connection interfaces.

The first chip package structure includes:
a package substrate;
a second connector, where the second connector is disposed on the package substrate, the second connector includes a plurality of second connection interfaces, the plurality of second connection interfaces correspond to the plurality of first connection interfaces of the first connector, and each second connection interface is connected to one or more corresponding first connection interfaces through one or more corresponding first wires; and
a chip, where the chip is disposed on the package substrate, and the chip is electrically connected to the second connector through the package substrate.

The wires may transmit, for example, an optical signal or an electrical signal. If the wires transmit an electrical signal, the plurality of first wires may be electrically connected between the first circuit board component and the first chip package structure. If the wires transmit an optical signal, the plurality of first wires may be optically connected between the first circuit board component and the first chip package structure.

In this application, two circuit board components are connected through a wire, so that the two circuit board components can exchange signals. Therefore, a single circuit board component can have fewer circuit boards without affecting the connection relationship. In other words, connection cabling can be implemented by using a wire, and the connection cabling may not be integrated on the circuit board. In this way, it is convenient to set a coefficient of thermal expansion of a circuit board on which a chip is disposed to be the same as or close to a coefficient of thermal expansion of the chip.

With reference to the first aspect, in some implementations of the first aspect, a difference between a coefficient of thermal expansion of the chip and a coefficient of thermal expansion of the package substrate is less than 5 ppm/°C.

In this application, in a case of a same temperature change, if a difference between a coefficient of thermal expansion of the circuit board and the coefficient of thermal expansion of the chip is smaller, a difference between a size change of the circuit board and a size change of the chip may be smaller. In this case, a fixed connecting part (for example, a solder or an adhesive) that fixes the chip on the circuit board can be subject to the smallest possible dimensional traction, thereby improving stability of connection between the circuit board and the chip.

With reference to the first aspect, in some implementations of the first aspect, the coefficient of thermal expansion of the chip is 2 to 7 ppm/°C, and the coefficient of thermal expansion of the package substrate is 2 to 7 ppm/°C.

In this application, the chip may be a silicon-based chip. The coefficient of thermal expansion of the circuit board may be the same as or close to that of the silicon-based chip.

With reference to the first aspect, in some implementations of the first aspect, a difference between the coefficient of thermal expansion of the chip and a coefficient of thermal expansion of the first circuit board is greater than 5 ppm/°C.

In this application, because there is no direct fixed relationship between the chip and the first circuit board, the difference between the coefficient of thermal expansion of the first circuit board and the coefficient of thermal expansion of the chip is large. This helps expand a material selection range of the first circuit board, and further helps improve comprehensive performance of the circuit board assembly, such as mechanical performance and costs.

With reference to the first aspect, in some implementations of the first aspect, the chip is a silicon-based chip; the package substrate includes a plurality of insulation layers and a plurality of conducting layers that are disposed in a stacked and spaced manner, one conducting layer is disposed between two adjacent insulation layers, one insulation layer is disposed between two adjacent conducting layers, and a material of the insulation layer includes at least one of the following: ceramic, glass, and diamond.

In this application, a coefficient of thermal expansion of a silicon-based chip is generally small. The insulation layer in the circuit board is disposed as a material with a small coefficient of thermal expansion, so that the coefficient of thermal expansion of the circuit board is the same as or close to the coefficient of thermal expansion of the silicon-based chip.

With reference to the first aspect, in some implementations of the first aspect, the chip includes a plurality of first chip interfaces and a plurality of second chip interfaces, and each first chip interface is electrically connected to one or more corresponding second connection interfaces through the package substrate.

The first circuit board component further includes:
a third connector, where the third connector is disposed on the first circuit board and is electrically connected to the first circuit board, and the third connector includes a plurality of third connection interfaces.

The first chip package structure further includes:
a fourth connector, where the fourth connector is disposed on the package substrate, the fourth connector includes a plurality of fourth connection interfaces, each fourth connection interface is electrically connected to one or more corresponding second chip interfaces through the package substrate, and the plurality of fourth connection interfaces correspond to the plurality of third connection interfaces.

The circuit board assembly further includes:
a plurality of second wires, where the plurality of second wires correspond to the plurality of third connection interfaces, and each third connection interface is connected to one or more corresponding fourth connection interfaces through one or more corresponding second wires. In this application, a plurality of connectors are disposed on both the first circuit board and the package substrate, so that the connection relationship between the first chip package structure and the first circuit board component can be more flexible, thereby implementing complex connection cabling. For example, a quantity of wires between the first chip package structure and the first circuit board component may be increased. For another example, it is convenient to implement a cabling network such as a tree-shaped or mesh-shaped network.

With reference to the first aspect, in some implementations of the first aspect, the first circuit board component further includes a second chip package structure, the second chip package structure is disposed on the first circuit board, and a signal between the first chip package structure and the second chip package structure is transmitted through the first circuit board, the first connector, and the plurality of first wires.

With reference to the first aspect, in some implementations of the first aspect, the circuit board assembly further includes a second circuit board component and a plurality of third wires, and the plurality of third wires are configured to transmit a signal between the second circuit board component and the first chip package structure.

The second circuit board component includes:
a third circuit board;
a fifth connector, where the fifth connector is disposed on the third circuit board, and the plurality of fifth connection interfaces, and the plurality of fifth connection interfaces correspond to the plurality of third wires; and
a third chip package structure, where the third chip package structure is disposed on the third circuit board, and the third chip package structure is electrically connected to the fifth connector through the third circuit board.

The first chip package structure further includes:
a sixth connector, where the sixth connector is disposed on the package substrate, the sixth connector is electrically connected to the chip through the package substrate, the sixth connector includes a plurality of sixth connection interfaces, the plurality of sixth connection interfaces correspond to the plurality of fifth connection interfaces of the fifth connector, and each sixth connection interface is connected to one or more corresponding fifth connection interfaces through one or more corresponding third wires.

In this application, a plurality of connectors and a plurality of wires are used to implement a tree-shaped cabling network in the circuit board assembly.

With reference to the first aspect, in some implementations of the first aspect, a function of the third chip package structure is different from a function of the second chip package structure.

In this application, functions of the plurality of chip package structures are different, so that a function of hardware can be flexibly determined. For example, the chip may process signals from the plurality of chip package structures. Other chip package structures may provide different preprocessing functions for the chip.

With reference to the first aspect, in some implementations of the first aspect, the second chip package structure is a preprocessing unit of the first chip package structure.

In this application, data processing functions of the plurality of chip package structures can be correspondingly implemented by planning electrical connection manners of the chip package structures.

With reference to the first aspect, in some implementations of the first aspect, the first circuit board component further includes:
a seventh connector, where the seventh connector is disposed on the first circuit board, the seventh connector is electrically connected to the first connector through the first circuit board, and the seventh connector includes a plurality of seventh connection interfaces.

The circuit board assembly further includes a third circuit board component and a plurality of fourth wires, where the plurality of fourth wires are configured to transmit a signal between the third circuit board component and the first circuit board component, and the plurality of fourth wires correspond to the plurality of seventh connection interfaces.

The third circuit board component includes:
a fourth circuit board;
an eighth connector, where the eighth connector is disposed on the fourth circuit board, the eighth connector includes a plurality of eighth connection interfaces corresponding to the plurality of seventh connection interfaces, and each eighth connection interface is connected to one or more corresponding seventh connection interfaces through one or more corresponding fourth wires; and
a fourth chip package structure, where the fourth chip package structure is disposed on the fourth circuit board, and the fourth chip package structure is electrically connected to the eighth connector through the fourth circuit board.

In this application, a line transfer board may be used. The line transfer board can be regarded as a signal transfer node. The line transfer board can implement more signal transmission manners, to implement a cabling network such as a tree-shaped or mesh-shaped network in the circuit board assembly.

With reference to the first aspect, in some implementations of the first aspect, the first circuit board is disposed parallel to the package substrate; and
the first circuit board and the package substrate are arranged in a direction perpendicular to the first circuit board; or
the package substrate is disposed on a plane on which the first circuit board is located. In this application, the first chip package structure and the first circuit board component are placed in parallel in a distributed manner. This helps reduce space occupied by the circuit board assembly in a thickness direction. The first chip package structure and the first circuit board component are stacked. This helps reduce space occupied by the circuit board assembly in horizontal and vertical directions (where the horizontal and vertical directions are perpendicular to the thickness direction). With reference to the first aspect, in some implementations of the first aspect, a connector and/or a connection interface through which a signal received/sent by the chip passes are/is determined by a signal type of the signal.

In this application, a connection interface identifier is associated with a signal type, so that a signal can be accurately input to a corresponding connection interface.

With reference to the first aspect, in some implementations of the first aspect, the signal type includes at least one of the following: an associated module, signal content, and a signal attribute. The associated module may be, for example, a receiving/sending module through which a transmitted signal passes. The signal content may include, for example, an image signal, an audio signal, and a control signal. The signal attribute may include, for example, a signal received by the chip, a signal sent by the chip, and the like.

Alternatively, the first chip package structure is any one of the following: a central processing unit, an application processor, a modem processor, a graphics processing unit, an image signal processor, a video codec, a digital signal processor, a baseband processor, a neural network processor, a biometric feature recognition module, a memory, a power management unit, and an optical chip. With reference to the first aspect, in some implementations of the first aspect, the first wire is a flexible wire.

The flexible wire facilitates an electrical connection between a plurality of electrical connecting parts.

According to a second aspect, an electronic device is provided, including a housing and the circuit board assembly according to any implementation of the first aspect, where the circuit board assembly is accommodated in the housing.

### BRIEF DESCRIPTION OF DRAWINGS

FIG. 1 is a schematic diagram of a structure of an electronic device;
FIG. 2 is a schematic diagram of a structure of a circuit board assembly;
FIG. 3 is a schematic diagram of a structure of another circuit board assembly;
FIG. 4 is a schematic diagram of a structure of a circuit board assembly according to an embodiment of this application;
FIG. 5 is a schematic diagram of a structure of a circuit board assembly according to an embodiment of this application;
FIG. 6 is a schematic diagram of a structure of a connector according to an embodiment of this application;
FIG. 7 is a schematic diagram of a structure of a circuit board assembly according to an embodiment of this application;
FIG. 8 is a schematic diagram of a structure of another circuit board assembly according to an embodiment of this application;
FIG. 9 is a schematic diagram of a structure of still another circuit board assembly according to an embodiment of this application;
FIG. 10 is a schematic diagram of a structure of still another circuit board assembly according to an embodiment of this application; and
FIG. 11 is a schematic diagram of a structure of still another circuit board assembly according to an embodiment of this application.

### DESCRIPTION OF EMBODIMENTS

The following describes technical solutions of this application with reference to accompanying drawings.

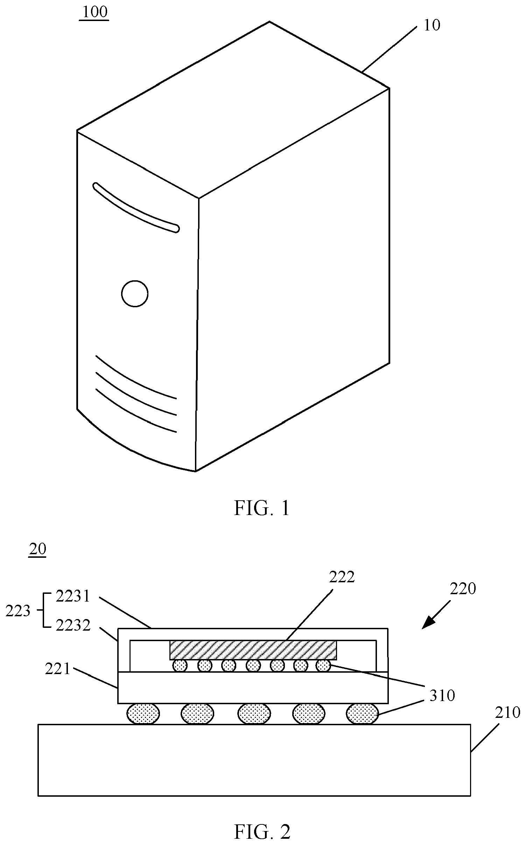

FIG. 1 is a schematic diagram of a structure of an electronic device 100 according to an embodiment of this application.

The electronic device 100 may be a server, a base station, a computer host, or the like. The electronic device 100 may alternatively be a device such as a mobile phone, a tablet computer, an e-reader, a notebook computer, a digital camera, a car, an in-vehicle device, an aviation instrument, a router, a smart speaker, an unmanned aerial vehicle, or a wearable device. An example in which the electronic device 100 is a server is used for description in the embodiment shown in FIG. 1. The electronic device 100 includes a housing 10 and a circuit board assembly (not shown in FIG. 1). The circuit board assembly may be accommodated in the housing 10. The housing 10 may further include a plurality of openings. Components on the circuit board assembly may be connected to the openings on the housing 10, to implement connections between the circuit board assembly and external components. For example, the circuit board assembly may include a universal serial bus (universal serial bus, USB) interface. The housing 10 may include an opening corresponding to the USB interface. A USB wire may pass through the opening on the housing, so that an end of the USB wire may be connected to the USB interface.

Interfaces of the circuit board assembly may further include, for example, an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), and a general-purpose input/output (general-purpose input/output, GPIO) interface.

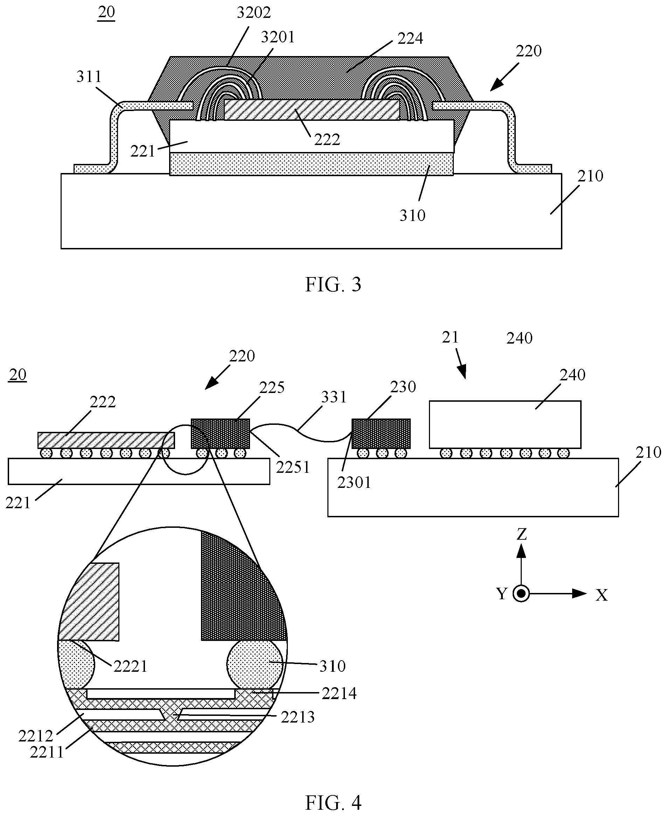

The circuit board assembly may include one or more circuit boards and one or more chip package structures electrically connected to the circuit boards. FIG. 2 and FIG. 3 show schematic diagrams of structures of two types of circuit board assemblies 20. In the examples shown in FIG. 2 and FIG. 3, one or more circuit boards of the circuit board assembly 20 may include a first circuit board 210. One or more chip package structures of the circuit board assembly 20 may include a chip package structure 220. The chip package structure 220 may be disposed on the first circuit board 210. The circuit board may be a printed circuit board (printed circuit board, PCB), a substrate, a flexible circuit board, or the like. According to a quantity of chip package structures carried on the circuit board, the circuit board may be a single-sided panel or a double-sided panel. The single-sided panel may be a circuit board that carries a chip package structure on a single side. The double-sided panel may be a circuit board that carries chip package structures on both sides. For example, the circuit board may be configured to carry a chip package structure, and transmit a signal for the chip package structure.

In an example, the chip package structure may be, for example, a central processing unit, an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural network processing unit (neural-network processing unit, NPU), a biometric feature recognition module, a system on chip (system on chip, SOC) module, a double data rate (double data rate, DDR) memory, a main power management unit (power management unit, PMU), an auxiliary PMU, a high-speed random access memory, a nonvolatile memory, or an optical chip. In another example, in addition to being a single chip package structure, the chip package structure may alternatively be obtained by stacking a plurality of chip package structures. For example, a processor and a memory may be stacked to form a package on package (package on package, PoP) module.

As shown in FIG. 2 and FIG. 3, the chip package structure 220 may include a chip 222. The chip 222 may be, for example, a silicon-based chip, a carbon-based chip, or the like.

Optionally, the chip may be, for example, independently used as a chip package structure.

Optionally, the chip package structure may further include another component other than the chip. As shown in FIG. 2 and FIG. 3, the chip package structure 220 may further include a package substrate 221. The chip 222 may be disposed on the package substrate 221. The package substrate 221 may be, for example, a substrate. The package substrate 221 may be located between the first circuit board 210 and the chip 222. The chip 222 may be electrically connected to the first circuit board 210 through the package substrate 221. In other words, the circuit board may be a part of the chip package structure. A circuit board inside the chip package structure may be configured to lay some lines of the chip package structure, and is configured to carry the chip of the chip package structure.

Optionally, the chip 222 may include a plurality of chip interfaces. The package substrate 221 may include a plurality of substrate interfaces corresponding to the plurality of chip interfaces. The chip package structure may include a plurality of electrical connection lines electrically connected between the chip interfaces and the substrate interfaces. The electrical connection lines may be, for example, lines disposed on the package substrate 221. For example, the chip 222 may include a chip interface A, the package substrate 221 may include a substrate interface A and an electrical connection line A, and the electrical connection line A may be electrically connected between the chip interface A and the substrate interface A.

In an example, the substrate interfaces of the package substrate 221 may be electrically connected to the chip interfaces of the chip 222 in a one-to-one manner.

In another example, the substrate interfaces of the package substrate 221 may be electrically connected to the chip interfaces of the chip 222 in a many-to-one manner. For example, the chip 222 may include a chip interface A, the package substrate 221 may include a substrate interface A and a substrate interface B, and the package substrate 221 may further include an electrical connection line A and an electrical connection line B. The electrical connection line A may be electrically connected between the chip interface A and the substrate interface A, and the electrical connection line B may be electrically connected between the chip interface A and the substrate interface B.

In still another example, the substrate interfaces of the package substrate 221 may be electrically connected to the chip interfaces of the chip 222 in a one-to-many manner. For example, the chip 222 may include a chip interface A and a chip interface B, and the package substrate 221 may include a substrate interface A. The package substrate 221 may further include an electrical connection line A and an electrical connection line C. The electrical connection line A may be electrically connected between the chip interface A and the substrate interface A, and the electrical connection line C may be electrically connected between the chip interface B and the substrate interface A.

The plurality of substrate interfaces on the package substrate 221 may serve as a plurality of interfaces of the chip package structure. The substrate interfaces may be located on a side that is of the package substrate 221 and that is away from the chip 222. A solder 310 on the first circuit board 210 may be connected to the substrate interfaces. A signal from the first circuit board 210 may be transmitted to the chip 222 through the substrate interfaces and the chip interfaces. A signal generated by the chip 222 may be transmitted to the first circuit board 210 through the chip interfaces and the substrate interfaces.

A plurality of components of the circuit board assembly may be fixed, for example, by using the solder. For example, the solder may be used for fixation between circuit boards, between a chip package structure and a circuit board, between a chip of a chip package structure and a circuit board of a chip package structure, and between a chip package structure 1 and a chip package structure 2. The solder may be used for a mechanical connection and/or an electrical connection, and a shape of the solder may be a spherical shape, a polyhedron shape, an ellipsoid shape, a round table shape, a chamfer shape, a strip shape, a rod shape, or the like.

As shown in FIG. 2 and FIG. 3, the package substrate 221 of the chip package structure 220 may be fixed to the first circuit board by using the solder 310, and the package substrate 221 of the chip package structure 220 may be fixed to the chip 222 of the chip package structure 220 by using the solder 310.

Embodiments of this application may not be limited to connecting the plurality of components of the circuit board assembly by using the solder. A manner of connecting the plurality of components of the circuit board assembly may further include, for example, a screw connection manner and a glue bonding manner.

In the example shown in FIG. 2, the chip package structure 220 may include a package substrate 221, a chip 222, and a cover 223. The cover 223 may include a cover body 2231 and a frame body 2232. The cover body 2231 and the frame body 2232 may be disposed perpendicular to each other. The cover body 2231 and the package substrate 221 may be disposed in parallel. The frame body 2232 may be connected between the cover body 2231 and the package substrate 221. A cavity formed between the cover 223 and the package substrate 221 may be configured to accommodate the chip 222.

In an example, the cover 223 may be, for example, a heat dissipating cover. The cover body 2231 of the cover 223 may be in contact with a surface that is of the chip 222 and that is away from the package substrate 221. The cover 223 may be, for example, configured to conduct heat generated by the chip 222, to reduce a risk of overheating of the chip 222.

In another example, the cover 223 may be, for example, a shielding cover. The cover 223 may be insulated from the chip 222. For example, the cover 223 may be configured to shield an external interference signal for the chip 222.

In the example shown in FIG. 3, the chip package structure 220 may include a package substrate 221, a chip 222, and a package material 224.

For example, the chip 222 may be disposed on the package substrate 221 by using glue. In another example, the chip 222 may alternatively be fixed to the package substrate 221 in another manner. The chip 222 may be electrically connected to the package substrate 221 through one or more first electrical connection leads 3201. The first electrical connection lead 3201 may be electrically connected between the chip 222 and the package substrate 221.

Optionally, in addition to use of the solder 310 for the electrical connection between the chip package structure 220 and the first circuit board 210, the chip package structure 220 may also be electrically connected to the first circuit board 210 through an electrical connecting part 311. In the example shown in FIG. 3, one end of the electrical connecting part 311 may be connected to the first circuit board 210, and the other end of the electrical connecting part 311 may be electrically connected to the chip 222 of the chip package structure 220 through one or more second connection leads 3202. The electrical connecting part 311 may serve as an electrical connection wire between the chip package structure 220 and the first circuit board 210.

The package material 224 may be wrapped around the periphery of the chip 222, and is in contact with a surface that is of the package substrate 221 and on which the chip 222 is disposed. The electrical connecting part 311 may be partially wrapped in the package material 224. A part of the electrical connecting part 311 may extend out of the package material 224. The package material 224 may further wrap at least a part of a side surface of the package substrate 221. The package material 224 may be exposed on a surface that is of the package substrate 221 and that is away from the chip 222. The package material 224 can be used to improve connection stability between the chip 222 and the package substrate 221. When the chip 222 works, the chip 222 may generate heat, and the chip 222 may be slightly deformed. The heat generated by the chip 222 may be further transferred to the package substrate 221 and the first circuit board 210. When the circuit board assembly 20 is heated or cold, the package substrate 221, the first circuit board 210, and the chip 222 may have unmatched deformation amounts. The package substrate 221 may bear stress from the chip 222 and the first circuit board 210, thereby reducing connection stability between the chip 222 and the package substrate 221 and between the package substrate 221 and the first circuit board 210.

For example, the chip 222 may be a silicon-based chip, and a coefficient of thermal expansion of the silicon-based chip may be, for example, approximately 2.6 ppm/°C. The package substrate 221 may be a substrate, and a coefficient of thermal expansion of the substrate may be, for example, 10 to 15 ppm/°C. The first circuit board 210 may be, for example, a printed circuit board, and a coefficient of thermal expansion of the printed circuit board may be, for example, 15 to 20 ppm/°C. In a case in which temperature rise conditions are the same, a thermal deformation amount of the printed circuit board may be large, a thermal deformation amount of the substrate may be second, and a thermal deformation amount of the silicon-based chip may be small. The substrate may be subject to deformation traction of the silicon-based chip and the printed circuit board, and connection stability between the substrate and the silicon-based chip and between the substrate and the printed circuit board may be poor.

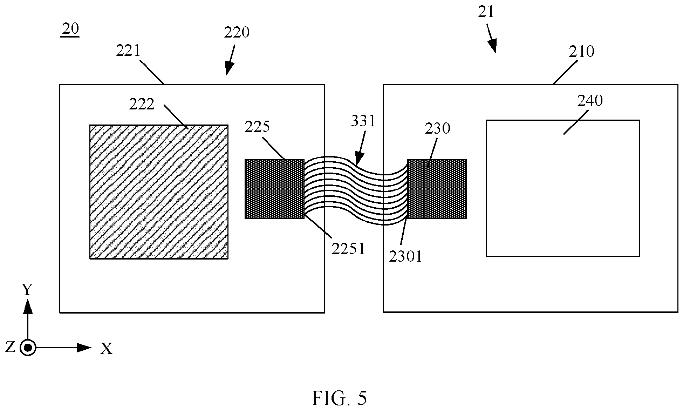

FIG. 4 and FIG. 5 show a circuit board assembly 20 according to an embodiment of this application. FIG. 4 and FIG. 5 are schematic diagram of structures of the circuit board assembly 20 from two angles of view respectively.

The circuit board assembly 20 may include a first circuit board component 21, a first chip package structure 220, and a plurality of first wires 331. The plurality of first wires 331 may be connected between the first circuit board component 21 and the first chip package structure 220, to transmit a signal between the first circuit board component 21 and the first chip package structure 220. The signal may be, for example, an optical signal or an electrical signal. If the signal is an electrical signal, the plurality of first wires 331 may be electrically connected between the first circuit board component 21 and the first chip package structure 220. If the signal is an optical signal, the plurality of first wires 331 may be optically connected between the first circuit board component 21 and the first chip package structure 220. In this embodiment of this application, the "connection" may include, for example, one or more of the following: a mechanical connection, an electrical connection, and an optical connection.

The first circuit board component 21 may include a first circuit board 210 and a first connector 230.

For example, the first connector 230 may be made of a material such as copper, aluminum, or stainless steel. The first connector 230 may transmit, for example, a plurality of signals in parallel. The first connector 230 may be disposed on the first circuit board 210. For example, by using a solder 310, the first connector 230 may be fixed to the first circuit board 210, and the first connector 230 may be electrically connected to the first circuit board 210 by using the solder 310. For another example, the first connector 230 may be fixed to the first circuit board 210 in a crimping manner. The first wire 331 may include an inner core and an outer cladding, and a material of the inner core may be, for example, copper, aluminum, or glass fiber. The outer cladding may be, for example, an insulating material. The plurality of first wires 331 may be connected between the first connector 230 and the first chip package structure 220, to implement signal transmission between the first circuit board 210 and the first chip package structure 220.

The first connector 230 may include a plurality of first connection interfaces 2301. The plurality of first connection interfaces 2301 may correspond to the plurality of first wires 331. First ends of the one or more first wires 331 may be, for example, plugged into the corresponding first connection interfaces 2301. The first connector 230 may be disposed, for example, in an edge area on the first circuit board 210, so that the plurality of first connection interfaces 2301 can be respectively connected to the plurality of first wires 331.

The first chip package structure 220 may be disposed outside the first circuit board 210. In other words, the first chip package structure 220 may not be disposed on the first circuit board 210. The first circuit board 210 may represent, for example, a general printed circuit board, where a coefficient of thermal expansion of the general printed circuit board may differ greatly from a coefficient of thermal expansion of the chip package structure 220. The first chip package structure 220 may be, for example, fixed to the housing of the electronic device 100 shown in FIG. 1, or fixed to a support in the electronic device 100.

The first chip package structure 220 may include a package substrate 221, a second connector 225, and a chip 222. For example, by using the solder 310, both the chip 222 and the second connector 225 may be disposed on the package substrate 221, and are electrically connected to the package substrate 221. The chip 222 may be electrically connected to the second connector 225 through the package substrate 221. Signals transmitted by the plurality of first wires 331 may be input to the first chip package structure 220 through the second connector 225, and the signals from the first chip package structure 220 may be output to the plurality of first wires 331 through the second connector 225. The second connector 225 may be disposed in an edge area on the package substrate 221, to connect to the plurality of first wires 331. Optionally, the first chip package structure 220 may further include the cover 223 shown in FIG. 2. Optionally, the first chip package structure 220 may further include the package material 224 shown in FIG. 3.

The chip 222 may include, for example, an integrated circuit, and a plurality of transistors (or logic gates) may be integrated on the integrated circuit. The transistors may be, for example, processing units or computing units of the chip 222.

Coefficients of thermal expansion of the chip 222 and the package substrate 221 may be close or the same. In other words, a difference between the coefficient of thermal expansion of the chip 222 and the coefficient of thermal expansion of the package substrate 221 may be less than a first preset threshold. For example, the coefficients of thermal expansion of the chip 222 and the package substrate 221 may both fall within a range of 2 to 7 ppm/°C. That the coefficients of thermal expansion of the chip 222 and the package substrate 221 are close or the same may indicate, for example, that the difference between the coefficient of thermal expansion of the chip 222 and the coefficient of thermal expansion of the package substrate 221 may be, for example, less than 5 ppm/°C. For example, the difference between the coefficient of thermal expansion of the chip 222 and the coefficient of thermal expansion of the package substrate 221 is less than 0.5 ppm/°C, or less than 1 ppm/°C, or less than 2 ppm/°C, or less than 3 ppm/°C, or less than 4 ppm/°C.

Optionally, a difference between the coefficient of thermal expansion of the chip 222 or the package substrate 221 and a coefficient of thermal expansion of the first circuit board 210 may be large. In other words, the difference between the coefficient of thermal expansion of the chip 222 and the coefficient of thermal expansion of the package substrate 221 may be greater than a second preset threshold, and the second preset threshold may be greater than the first preset threshold. For example, the difference between the coefficient of thermal expansion of the chip 222 and the coefficient of thermal expansion of the first circuit board 210 may be, for example, greater than 1 ppm/°C. For example, the difference between the coefficient of thermal expansion of the chip 222 and the coefficient of thermal expansion of the first circuit board 210 may be greater than 3 ppm/°C, or greater than 5 ppm/°C, or greater than 7 ppm/°C, or greater than 10 ppm/°C, or greater than 15 ppm/°C.

Compared with the examples shown in FIG. 2 and FIG. 3, in the examples shown in FIG. 4 and FIG. 5, a deformation amount of the package substrate 221 when deformed due to heat or cold may be small, and flatness of the package substrate 221 may be high. In addition, because the coefficients of thermal expansion of the package substrate 221 and the chip 222 are as same as possible, deformation amounts of the package substrate 221 and the chip 222 may be close, and deformation amounts of the package substrate 221 and the chip 222 caused by temperature changes may be close or match. Therefore, connection stability between the package substrate 221 and the chip 222 is improved. Because the first chip package structure 220 may be disposed outside the first circuit board 210, deformation of the first chip package structure 220 may have small impact on the first circuit board 210. This helps reduce stress borne by the first circuit board 210 and improve mechanical stability of the first circuit board 210. Heat from the chip 222 can hardly affect the first circuit board 210. This helps reduce the deformation amount of the first circuit board 210, and helps improve flatness of the first circuit board 210.

As shown in a partial enlarged diagram in FIG. 4, the package substrate 221 may include a plurality of conducting layers 2211 and a plurality of insulation layers 2212. The plurality of conducting layers 2211 and the plurality of insulation layers 2212 may be disposed in a stacked and spaced manner. One insulation layer 2212 is disposed between two adjacent conducting layers 2211. One conducting layer 2211 is disposed between two adjacent insulation layers 2212. Two conducting layers 2211 may be electrically connected, for example, by a through hole 2213. The plurality of conducting layers 2211 may form electrical connection lines on the package substrate 221. To cause the coefficient of thermal expansion of the package substrate 221 to be close to the coefficient of thermal expansion of the chip 222, the insulation layer 2212 may be made of, for example, a material such as a ceramic material.

The conducting layer 2211 may be, for example, copper. A pad 2214 may be disposed between the solder 310 and the conducting layers 2211. A material of the pad 2214 may be different from that of the conducting layers 2211. The pad 2214 may be, for example, a tin plated layer or a nickel plated layer. In one aspect, the pad 2214 helps improve soldering reliability, so that the chip 222 can be fixed to the package substrate 221 by using the solder 310. In another aspect, the pad 2214 can be used to prevent the electrical connection lines on the conducting layers 2211 from being exposed to air, thereby reducing corrosion and damage of the air to the electrical connection lines. As shown in FIG. 4, the chip 222 may be electrically connected to the second connector 225 by using the solder 310, the pad 2214 on the package substrate 221, and the at least one conducting layer 2211.

The chip 222 may include a plurality of chip interfaces 2221. The chip interface 2221 may be, for example, formed by a pin of an integrated circuit, the pad 2214, or the like. The chip interface 2221 may transmit, for example, a signal, such as an electrical signal, a radio frequency signal, or a digital signal. A signal can be input to the chip 222 through the chip interface 2221 on the chip 222. The chip 222 may process the signal. Through the chip interface 2221 on the chip 222, the signal processed by the chip 222 may be output from the chip 222 to another module.

The chip 222 may include a plurality of first chip interfaces. The second connector 225 may include a plurality of second connection interfaces 2251 corresponding to the plurality of first chip interfaces.

For example, the chip 222 may include a first chip interface A. The second connector 225 may include a second connection interface 2251A. The first chip package structure 220 may further include an electrical connection line electrically connected between the first chip interface A and the second connection interface 2251A. The electrical connection line may include, for example, a line disposed on the package substrate 221.

In an example, the second connection interfaces 2251 of the second connector 225 may be electrically connected to the first chip interfaces of the chip 222 in a one-to-one manner.

In another example, the second connection interfaces 2251 of the second connector 225 may be electrically connected to the first chip interfaces of the chip 222 in a many-to-one manner. For example, the chip 222 may include a first chip interface A, the second connector 225 may include a second connection interface 2251A and a second connection interface 2251B, and the first chip package structure 220 may further include an electrical connection line A and an electrical connection line B. The electrical connection line A may be electrically connected between the first chip interface A and the second connection interface 2251A, and the electrical connection line B may be electrically connected between the first chip interface A and the second connection interface 2251B. The electrical connection line A and the electrical connection line B may include, for example, lines disposed on the package substrate 221.

In still another example, the second connection interface 2251 of the second connector 225 may be electrically connected to the first chip interface of the chip 222 in a one-to-many manner. For example, the chip 222 may include a first chip interface A and a first chip interface B, and the second connector 225 may include a second connection interface 2251A. The second connector 225 may further include an electrical connection line A and an electrical connection line C. The electrical connection line A may be electrically connected between the first chip interface A and the second connection interface 2251A, and the electrical connection line C may be electrically connected between the first chip interface B and the second connection interface 2251A. The electrical connection line A and the electrical connection line C may include, for example, lines disposed on the package substrate 221.

The plurality of second connection interfaces 2251 on the second connector 225 may serve as a plurality of first interfaces of the chip package structure. In other words, the first connector 230 may be connected to the first interfaces of the first chip package structure 220 by connecting the first connector 230 to the second connection interfaces 2251. The plurality of first connection interfaces 2301 of the first connector 230 may correspond to the plurality of second connection interfaces 2251 of the second connector 225. The plurality of first connection interfaces 2301 and the plurality of second connection interfaces 2251 may be connected, for example, in at least one of the following connection modes: one-to-many, many-to-one, and one-to-one. For the three connection modes: one-to-many, many-to-one, and one-to-one, respectively refer to the three electrical connection modes: one-to-many, many-to-one, and one-to-one that are described in detail above. Details are not described herein again.

As shown in FIG. 4 and FIG. 5, the plurality of first connection interfaces 2301 of the first connector 230 may correspond to the plurality of second connection interfaces 2251 of the second connector 225. The plurality of first connection interfaces 2301 and the plurality of second connection interfaces 2251 may be connected, for example, in a one-to-one, one-to-many, or many-to-one manner. Each first connection interface 2301 may be connected to one or more corresponding second connection interfaces 2251 through one or more corresponding first wires 331. Second ends of the first wires 331 may be plugged into the second connection interfaces 2251 of the second connector 225.

Optionally, the first circuit board component 21 may further include, for example, a second chip package structure 240. Optionally, the second chip package structure 240 may be disposed on the first circuit board 210, and is electrically connected to the first circuit board 210. As shown in FIG. 4, a signal between the second chip package structure 240 and the first chip package structure 220 may be transmitted through the plurality of first wires 331, the first connector 230, and the first circuit board 210. Optionally, a signal may be converted on a transmission path. For example, an optical signal is converted into an electrical signal, or an electrical signal is converted into an optical signal. A signal from the second chip package structure 240 may be transmitted to the chip 222 through the first circuit board 210, the first connector 230, the first wires 331, the second connector 225, and the package substrate 221. Correspondingly, a signal generated by the chip 222 may be transmitted to the chip 222 through the package substrate 221, the second connector 225, the first wires 331, the first connector 230, and the first circuit board 210. Optionally, a coefficient of thermal expansion of the second chip package structure 240 may be close to or the same as the coefficient of thermal expansion of the first circuit board 210.

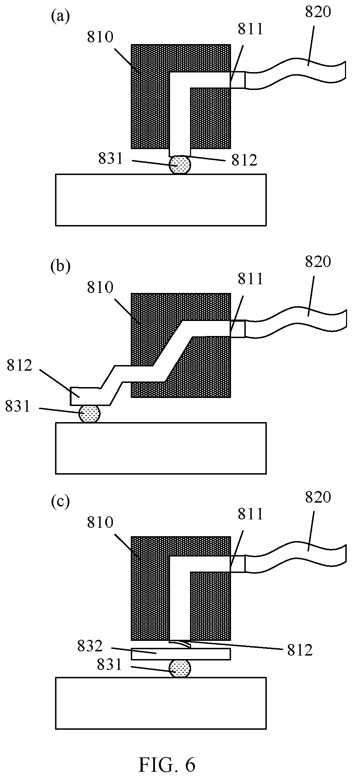

FIG. 6 is a schematic diagram of a structure of a connector 810. The connector 810 shown in FIG. 6 may be, for example, any connector provided in embodiments of this application. Wires 820 shown in FIG. 6 may be, for example, any wire provided in embodiments of this application.

The connector 810 may include a plurality of first interfaces 811 and a plurality of second interfaces 812. Inside the connector 810, the plurality of first interfaces 811 may be connected to the plurality of second interfaces 812 in at least one of the following connection modes: one-to-many, many-to-one, and one-to-one.

The first interfaces 811 may be connected to the wires 820. As shown in (a) to (c) in FIG. 6, the wires 820 may be connected to the first interfaces 811 in a manner of crimping, plug-in, welding, or the like.

The second interfaces 812 may be electrically connected to a package substrate or a circuit board, for example, through one or more electrical connecting parts.

As shown in (a) in FIG. 6, the second interface 812 may extend from a side that is of the connector 810 and that is close to the package substrate or the circuit board, and is electrically connected to the package substrate or the circuit board by using a solder 831.

As shown in (b) in FIG. 6, the second interface 812 may extend from a side surface that is of the connector 810 and that is perpendicular to the package substrate or the circuit board, and is electrically connected to the package substrate or the circuit board by using the solder 831.

In the examples shown in (a) and (b) in FIG. 6, one or more electrical connecting parts connected between the second interface 812 and the package substrate, or connected between the second interface 812 and the package substrate may include the solder 831. In another example, the solder 831 may be replaced, for example, with a conductive material such as a conductive adhesive.

As shown in (c) in FIG. 6, a socket 832 may be disposed on the package substrate or the circuit board. The socket 832 may be electrically connected to the package substrate or the circuit board by using the solder 831. The second interface 812 may be electrically connected to the package substrate or the circuit board through the socket 832. The second interface 812 may be, for example, formed by a conductive elastomer. The conductive elastomer may be disposed on an end face that is of the connector 810 and that is close to the package substrate or the circuit board, and abuts against the socket 832. In the example shown in (c) in FIG. 6, one or more electrical connecting parts connected between the second interface 812 and the package substrate, or between the second interface 812 and the package substrate may include the socket 832 and the solder 831 that is connected between the socket 832 and the package substrate or a circuit board. In another example, the conductive elastomer may be replaced with a conductive material such as the solder 831 or conductive adhesive.

When the wire 820 is an optical wire 820, the first interface 811 may be configured to transmit an optical signal, and the second interface 812 may be configured to transmit an electrical signal. The connector 810 may have an optical-to-electrical conversion function. When the wire 820 is an electrical wire 820, both the first interface 811 and the second interface 812 may be configured to transmit an electrical signal.

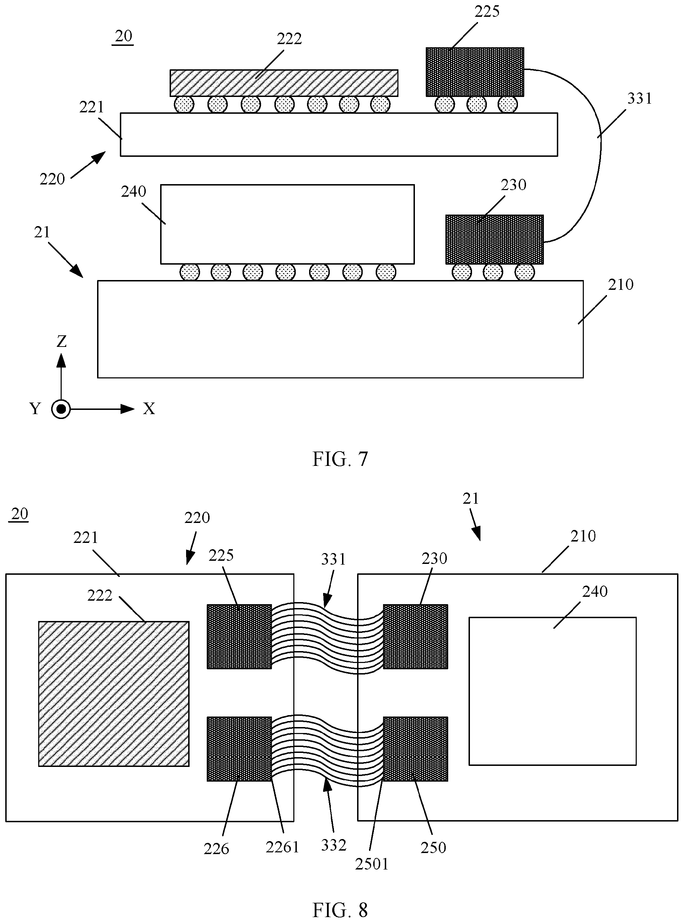

To facilitate connection of the first wire 331 between the first connector 230 and the second connector 225, a distance between the second connector 225 of the first chip package structure 220 and the first connector 230 may be less than a preset distance. With reference to FIG. 4 and FIG. 7, the following describes a plurality of placement forms for the first chip package structure 220 and the first circuit board component 21.

It is assumed that an XYZ coordinate system exists in space. A Z-axis direction may be set parallel to a thickness direction of the first circuit board 210. The thickness direction of the first circuit board 210 may be a stacking direction of the plurality of conducting layers 2211 and the plurality of insulation layers 2212 of the first circuit board 210. A plane perpendicular to the Z-axis direction may be an XY plane. The first circuit board 210 may be disposed parallel to the XY plane. One or more components of the first circuit board component 21 may be disposed on a surface of the first circuit board 210 that is disposed parallel to the XY plane.

In the example shown in FIG. 4, the package substrate 221 of the first chip package structure 220 may be disposed parallel to the first circuit board 210. For example, the package substrate 221 may be disposed on a plane on which the first circuit board 210 is located. The plane on which the first circuit board 210 is located may be a plane that is parallel to the first circuit board 210 and passes through the first circuit board 210. That the package substrate 221 is disposed on the plane on which the first circuit board 210 is located may indicate that a plane on which the package substrate 221 is located is the same plane as the plane on which the first circuit board 210 is located, where the plane on which the package substrate 221 is located may be disposed parallel to the package substrate 221, and the plane on which the package substrate 221 is located may pass through the package substrate 221.

As shown in FIG. 4, a projection area of the first circuit board 210 on the XY plane may be a first XY projection area, and a projection area of the first chip package structure 220 on the XY plane is a second XY projection area. The first XY projection area and the second XY projection area may not be connected to each other, intersect each other, or overlap each other. In the example shown in FIG. 4, a projection area of the first wires 331 on the XY plane may be connected between the first XY projection area and the second XY projection area.

In the example shown in FIG. 7, the package substrate 221 of the first chip package structure 220 may be disposed parallel to the first circuit board 210. The package substrate 221 and the first circuit board 210 may be arranged in a direction perpendicular to the first circuit board 210. The direction perpendicular to the first circuit board 210 may be set parallel to a thickness direction of the first connector 230.

As shown in FIG. 7, a projection range of the first connector 230 on the Z-axis is a first Z-direction projection range, and a projection range of the first chip package structure 220 on the Z-axis is a second Z-direction projection range. The first Z-direction projection range and the second Z-direction projection range may be not connected to each other, intersect each other, or overlap each other. In the example shown in FIG. 4, a projection range of the first wires 331 on the Z-axis may be connected between the first Z-direction projection range and the second Z-direction projection range.

FIG. 4 and FIG. 7 are merely two examples of the position relationship between the first chip package structure 220 and the first circuit board component 21. The first chip package structure 220 and the first circuit board component 21 may also be placed in another form. Other placement forms may include, for example, a ladder-shaped placement form and a bridge-shaped placement form. The position relationship between the first chip package structure 220 and the first circuit board component 21 is not limited to the examples shown in FIG. 4 and FIG. 7.

FIG. 8 is a schematic diagram of a structure of another circuit board assembly 20 according to an embodiment of this application. Similar to the circuit board assembly 20 shown in FIG. 4, the coefficient of thermal expansion of the package substrate 221 may be the same as or close to the coefficient of thermal expansion of the chip 222. Optionally, the coefficient of thermal expansion of the second chip package structure 240 may be close to or the same as the coefficient of thermal expansion of the first circuit board 210.

Different from the circuit board assembly 20 shown in FIG. 4, the first circuit board component 21 may further include a third connector 250, and the third connector 250 may be disposed on the first circuit board 210. The first chip package structure 220 may further include a fourth connector 226. The third connector 250 may be connected to the fourth connector 226 through a plurality of second wires 332.

The chip 222 may further include a plurality of second chip interfaces. The fourth connector 226 may include a plurality of fourth connection interfaces 2261 corresponding to the plurality of second chip interfaces. The plurality of second chip interfaces may be electrically connected to the plurality of fourth connection interfaces 2261, for example, in a one-to-one, one-to-many, or many-to-one manner. The fourth connection interfaces 2261 may serve as at least a part of interfaces of the first chip package structure 220.

The third connector 250 may include a plurality of third connection interfaces 2501 corresponding to the plurality of fourth connection interfaces 2261. The plurality of fourth connection interfaces 2261 and the plurality of third connection interfaces 2501 may be connected, for example, in a one-to-one, one-to-many, or many-to-one manner. In the example shown in FIG. 8, the third connector 250 may include a plurality of third connection interfaces 2501 that are in a one-to-one correspondence with the plurality of fourth connection interfaces 2261. The plurality of third connection interfaces 2501 may be in a one-to-one correspondence with the plurality of second wires 332. Each third connection interface 2501 may be connected to one or more corresponding fourth connection interfaces 2261 through one or more corresponding second wires 332.

It is assumed that the chip 222 may include 300 chip interfaces. A quantity of interfaces of a single connector disposed on the first circuit board 210 and the first chip package structure 220 may be limited. For example, one connector may include 10 to 50 interfaces. To match a quantity of chip interfaces, the first chip package structure 220 may be, for example, provided with six connectors each having 50 interfaces. Correspondingly, the first circuit board 210 may also be provided with six connectors each having 50 interfaces. A plurality of connectors are configured in the first chip package structure 220, to help fully use the chip interfaces.

A signal between the first chip package structure 220 and the second chip package structure 240 may be transmitted through a connector on the first circuit board 210. A connector identifier may indicate the connector through which the signal passes. A connection interface through which the signal passes may be indicated by using a connection interface identifier.

In an example, a signal between the second chip package structure 240 and the first chip package structure 220 may be transmitted through the first circuit board 210 and the first connector 230, or may be transmitted through the first circuit board 210 and the third connector 250. The connection interface identifier may be, for example, corresponding to one first connection interface 2301 of the first connector 230 (that is, corresponding to one second connection interface 2251 of the second connector 225), or one third connection interface 2501 of the third connector 250 (that is, corresponding to one fourth connection interface 2261 of the fourth connector 226).

The connection interface identifier is associated with the signal type, so that the signal can be input to the corresponding connection interface accurately. The signal type may be, for example, determined by an associated module, signal content, or a signal attribute. The associated module may be, for example, a receiving/sending module through which a transmitted signal passes. The signal content may include, for example, an image signal, an audio signal, and a control signal. The signal attribute may include, for example, a signal received by the chip 222 and a signal sent by the chip 222.

In a possible example, the connection interface identifier may correspond to the signal attribute. In other words, the signal transmission module may determine the connection interface identifier based on the signal attribute.

For example, the first connector 230 may be an output connector, the second connector 225 may be an input connector, the third connector 250 may be an input connector, and the fourth connector 226 may be an output connector. When the second chip package structure 240 sends a signal A to the chip 222 of the first chip package structure 220, a signal attribute of the signal A may be a signal received by the chip 222. The second chip package structure 240 may determine that the signal A may be output through the first connector 230, and input from the second connector 225 to the chip 222 of the first chip package structure 220. When the chip 222 of the first chip package structure 220 sends a signal B to the second chip package structure 240, the chip 222 may determine that the signal B may be output through the fourth connector 226, and input from the third connector 250 to the second chip package structure 240.

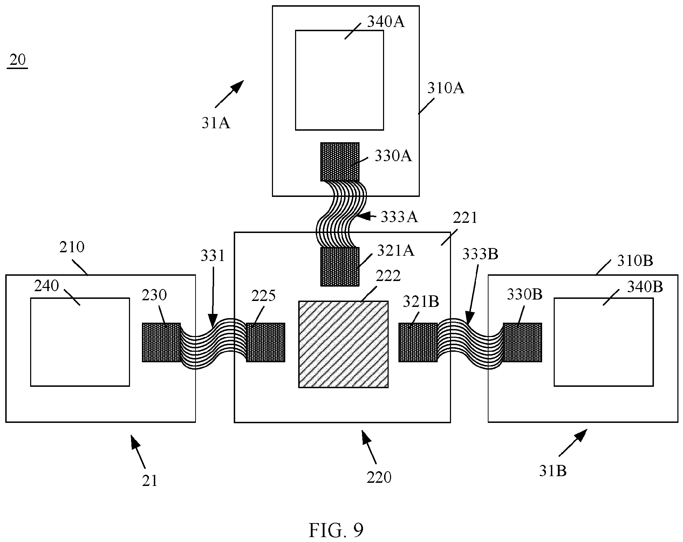

FIG. 9 is a schematic diagram of a structure of still another circuit board assembly 20 according to an embodiment of this application. The circuit board assembly 20 may include a first circuit board component 21, a second circuit board component 31A, and a circuit board component 31B. The first circuit board component 21 may include a first circuit board 210, a first connector 230, and a second chip package structure 240. The first connector 230 and the second chip package structure 240 may be disposed on the first circuit board 210. Optionally, a coefficient of thermal expansion of the second chip package structure 240 may be close to or the same as a coefficient of thermal expansion of the first circuit board 210.

The second circuit board component 31A may include a first circuit board 310A, a fifth connector 330A, and a third chip package structure 340A. The fifth connector 330A and the third chip package structure 340A may be disposed on the first circuit board 310A. Optionally, a coefficient of thermal expansion of the third chip package structure 340A may be close to or the same as a coefficient of thermal expansion of the first circuit board 310A.

The second circuit board component 31B may include a first circuit board 310B, a fifth connector 330B, and a third chip package structure 340B. The fifth connector 330B and the third chip package structure 340B may be disposed on the first circuit board 310B. Optionally, a coefficient of thermal expansion of the third chip package structure 340B may be close to or the same as a coefficient of thermal expansion of the first circuit board 310B.

The circuit board assembly 20 may further include a first chip package structure 220. The first chip package structure 220 may include a chip 222, a package substrate 221, a second connector 225, a sixth connector 321A, and a sixth connector 321B. The second connector 225, the sixth connector 321A, and the sixth connector 321B may all be disposed on the package substrate 221. The second connector 225, the sixth connector 321A, and the sixth connector 321B may all be electrically connected to the chip 222 through the package substrate 221. Similar to the circuit board assembly 20 shown in FIG. 4, a coefficient of thermal expansion of the package substrate 221 may be the same as or close to a coefficient of thermal expansion of the chip 222.

The circuit board assembly 20 may further include first wires 331, third wires 333A, and third wires 333B. The first wires 331 may be connected between the first connector 230 and the second connector 225. The third wires 333A may be connected between the fifth connector 330A and the sixth connector 321A. The third wires 333B may be connected between the fifth connector 330B and the sixth connector 321B.

The circuit board assembly 20 shown in FIG. 9 may provide a tree-shaped distributed module architecture. In another example, the circuit board assembly 20 may include more or fewer chip package structures and more or fewer connectors.

When any one of the second chip package structure 240, the third chip package structure 340A, and the third chip package structure 340B sends a signal to the chip 222 of the first chip package structure 220, because of the existing connection relationship, a connector conflict generally does not occur when the chip 222 receives the signal.

When the chip 222 of the first chip package structure 220 is ready to send a signal to any one of the second chip package structure 240, the third chip package structure 340A, and the third chip package structure 340B, the chip 222 needs to determine a correct connector and/or connection interface, so that the corresponding second chip package structure 240 can receive the signal. For example, the chip 222 may determine a connector identifier and/or an interface identifier corresponding to the signal based on one or more of an associated device of the signal, signal content, and a signal attribute.

In a possible example, the second chip package structure 240 may be, for example, a power management module. The third chip package structure 340A may be, for example, an audio/video codec module. The third chip package structure 340B may be, for example, a neural network processing module. The first chip package structure 220 may be, for example, a central processing module of the electronic device.

Because the second chip package structure 240, the third chip package structure 340A, and the third chip package structure 340B may separately manage different functions of the electronic device, types of signals transmitted by the second chip package structure 240, the third chip package structure 340A, and the third chip package structure 340B respectively may be different. A signal received/sent by the second chip package structure 240 (namely, the power management module) may be, for example, a power control signal. A signal received/sent by the third chip package structure 340A (the audio/video coding module) may be, for example, an audio/video signal. A signal received/sent by the third chip package structure 340B (the neural network processing module) may be, for example, an artificial intelligence signal. The chip 222 may determine, from the plurality of connectors based on signal content, a target connector corresponding to a target chip package structure (for example, any one of the second chip package structure 240, the third chip package structure 340A, and the third chip package structure 340B). In another example, the second chip package structure 240, the third chip package structure 340A, and the third chip package structure 340B may alternatively be chip package structures having other functions.

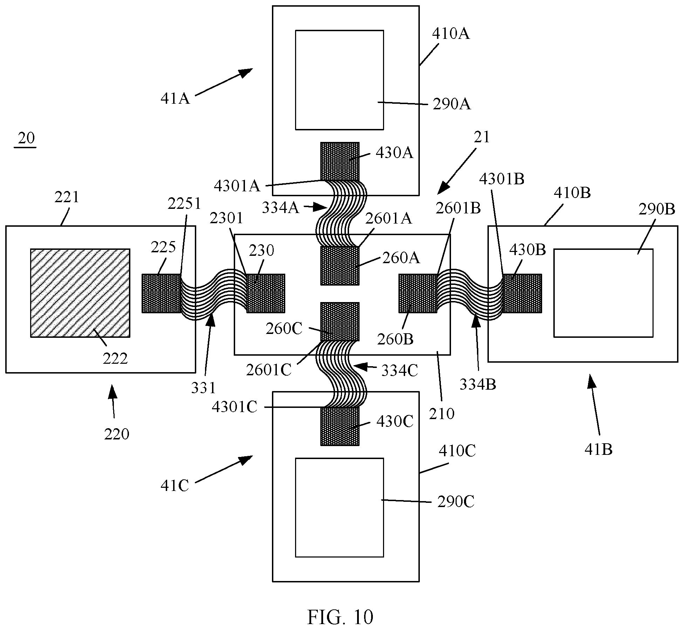

FIG. 10 is a schematic diagram of a structure of still another circuit board assembly 20 according to an embodiment of this application. The circuit board assembly 20 may include a first circuit board component 21, a third circuit board component 41A, a third circuit board component 41B, and a third circuit board component 41C.

The first circuit board component 21 may include a first circuit board 210, a first connector 230, a seventh connector 260A, a seventh connector 260B, and a seventh connector 260C. The first connector 230, the seventh connector 260A, the seventh connector 260B, and the seventh connector 260C may all be disposed on the first circuit board 210. The first connector 230 may be electrically connected to the seventh connector 260A through the first circuit board 210. The first connector 230 may be electrically connected to the seventh connector 260B through the first circuit board 210. The first connector 230 may be electrically connected to the seventh connector 260C through the first circuit board 210.

The third circuit board component 41A may include a fourth circuit board 410A, an eighth connector 430A, and a fourth chip package structure 290A. The eighth connector 430A and the fourth chip package structure 290Amay be disposed on the fourth circuit board 410A. The eighth connector 430A may include a plurality of eighth connection interfaces 4301A. Optionally, a coefficient of thermal expansion of the fourth chip package structure 290A may be close to or the same as a coefficient of thermal expansion of the fourth circuit board 410A.

The third circuit board component 41B may include a fourth circuit board 410B, an eighth connector 430B, and a fourth chip package structure 290B. The eighth connector 430B and the fourth chip package structure 290B may be disposed on the fourth circuit board 410B. The eighth connector 430B may include a plurality of eighth connection interfaces 4301B. Optionally, a coefficient of thermal expansion of the fourth chip package structure 290B may be close to or the same as a coefficient of thermal expansion of the fourth circuit board 410B.

The third circuit board component 41C may include a fourth circuit board 410C, an eighth connector 430C, and a fourth chip package structure 290C. The eighth connector 430C and the fourth chip package structure 290C may be disposed on the fourth circuit board 410C. The eighth connector 430C may include a plurality of eighth connection interfaces 4301C. Optionally, a coefficient of thermal expansion of the fourth chip package structure 290C may be close to or the same as a coefficient of thermal expansion of the fourth circuit board 410C.

The circuit board assembly 20 may further include a first chip package structure 220. The first chip package structure 220 may include a chip 222, a package substrate 221, and a second connector 225. The second connector 225 may be disposed on the package substrate 221. The second connector 225 may be electrically connected to the chip 222 through the package substrate 221. The second connector 225 may include a plurality of second connection interfaces 2251. Similar to the circuit board assembly 20 shown in FIG. 4, a coefficient of thermal expansion of the package substrate 221 may be the same as or close to a coefficient of thermal expansion of the chip 222. The first connector 230 may include a plurality of first connection interfaces 2301 corresponding to the plurality of second connection interfaces 2251. The seventh connector 260A may include a plurality of seventh connection interfaces 2601A corresponding to the plurality of eighth connection interfaces 4301A. The seventh connector 260B may include a plurality of seventh connection interfaces 2601B corresponding to the plurality of eighth connection interfaces 4301B. The seventh connector 260C may include a plurality of seventh connection interfaces 2601C corresponding to the plurality of eighth connection interfaces 4301C.

The circuit board assembly 20 may further include a plurality of first wires 331, a plurality of fourth wires 334A, a plurality of fourth wires 334B, and a plurality of fourth wires 334C. The plurality of first wires 331 may be connected between the second connector 225 and the first connector 230. Each second connection interface 2251 may be connected to one or more corresponding first connection interfaces 2301 through one or more first wires 331. The fourth wires 334A may be connected between the eighth connector 430A and the seventh connector 260A. Each eighth connection interface 4301A may be connected to one or more corresponding seventh connection interfaces 2601A through one or more fourth wires 334A. The fourth wires 334B may be connected between the eighth connector 430B and the second connector 225C. Each eighth connection interface 4301B may be connected to one or more corresponding seventh connection interfaces 2601B through one or more fourth wires 334B. The fourth wires 334C may be connected between the eighth connector 430C and the second connector 225D. Each eighth connection interface 4301C may be connected to one or more corresponding seventh connection interfaces 2601C through one or more fourth wires 334C.

The circuit board assembly 20 shown in FIG. 10 may provide a tree-shaped distributed module architecture. In another example, the circuit board assembly 20 may include more or fewer chip package structures 290 and more or fewer connectors 230.

Optionally, a first portion of the plurality of first connection interfaces 2301 may be connected to the seventh connector 260A, a second portion of the plurality of first connection interfaces 2301 may be connected to the seventh connector 260B, and a third portion of the plurality of first connection interfaces 2301 may be connected to the seventh connector 260C. The first portion, the second portion, and the third portion may partially intersect, may be completely different, or may be completely the same. When any one of the fourth chip package structure 290A, the fourth chip package structure 290B, and the fourth chip package structure 290C sends a signal to the chip 222 of the first chip package structure 220, because of the existing connection relationship, a connector conflict does not occur when the chip 222 receives the signal.

When the chip 222 of the first chip package structure 220 is ready to send a signal to any one of the fourth chip package structure 290A, the fourth chip package structure 290B, and the fourth chip package structure 290C, the chip 222 needs to determine at least a correct connector and/or interface of the first connector 230, so that the corresponding chip package structure can receive the signal. Because the fourth chip package structure 290A, the fourth chip package structure 290B, and the fourth chip package structure 290C may separately manage different functions of the electronic device, types of signals transmitted by the fourth chip package structure 290A, the fourth chip package structure 290B, and the fourth chip package structure 290C may be different, for example, associated devices of the signals, signal content, and signal attributes are different. The chip 222 may determine, from the plurality of connection interfaces based on one or more of the associated device, the signal content, and the signal attribute, a target connection interface corresponding to the target chip package structure (for example, any one of the fourth chip package structure 290A, the fourth chip package structure 290B, and the fourth chip package structure 290C).

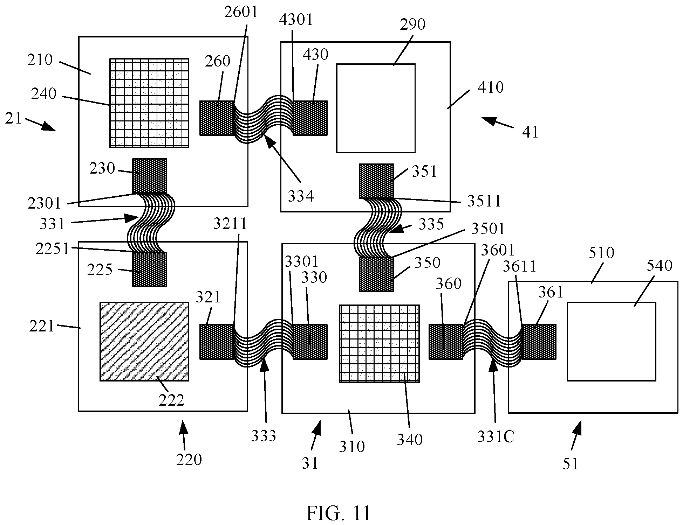

FIG. 11 is a schematic diagram of a structure of still another circuit board assembly 20 according to an embodiment of this application.

The circuit board assembly 20 may include a first circuit board component 21, a second circuit board component 31, a third circuit board component 41, and a fourth circuit board component 51. The first circuit board component 21 may include a first circuit board 210, a second chip package structure 240, a first connector 230, and a seventh connector 260. The first connector 230, the seventh connector 260, and the second chip package structure 240 may all be disposed on the first circuit board 210. Both the first connector 230 and the seventh connector 260 may be electrically connected to the second chip package structure 240 through the first circuit board 210. Optionally, a coefficient of thermal expansion of the second chip package structure 240 may be close to or the same as a coefficient of thermal expansion of the first circuit board 210.

The second circuit board component 31 may include a third circuit board 310, a third chip package structure 340, a fifth connector 330, a ninth connector 350, and a tenth connector 360. The fifth connector 330, the ninth connector 350, the tenth connector 360, and the third chip package structure 340 may all be disposed on the third circuit board 310. The fifth connector 330, the ninth connector 350, and the tenth connector 360 may all be electrically connected to the third chip package structure 340 through the third circuit board 310. Optionally, a coefficient of thermal expansion of the third chip package structure 340 may be close to or the same as a coefficient of thermal expansion of the third circuit board 310.

The third circuit board component 41 may include a fourth circuit board 410, an eighth connector 430A, an eleventh connector 351, and a fourth chip package structure 290. The eighth connector 430A, the eleventh connector 351, and the fourth chip package structure 290 may all be disposed on the fourth circuit board 410, and are electrically connected to the fourth circuit board 410. Optionally, a coefficient of thermal expansion of the fourth chip package structure 290 may be close to or the same as a coefficient of thermal expansion of the fourth circuit board 410.

The fourth circuit board component 51 may include a fifth circuit board 510, a twelfth connector 361, and a fifth chip package structure 540. Both the twelfth connector 361 and the fifth chip package structure 540 may be disposed on the fifth circuit board 510, and are electrically connected to the fifth circuit board 510. Optionally, a coefficient of thermal expansion of the fifth chip package structure 540 may be close to or the same as a coefficient of thermal expansion of the fifth circuit board 510.

The circuit board assembly 20 may further include a first chip package structure 220. The first chip package structure 220 may include a chip 222, a package substrate 221, a second connector 225, and a sixth connector 321. Both the second connector 225 and the sixth connector 321 may be disposed on the package substrate 221. Both the second connector 225 and the sixth connector 321 may be electrically connected to the chip 222 through the package substrate 221. The second connector 225 may include a plurality of second connection interfaces 2251. The sixth connector 321 may include a plurality of sixth connection interfaces 3211. Similar to the circuit board assembly 20 shown in FIG. 4, a coefficient of thermal expansion of the package substrate 221 may be the same as or close to a coefficient of thermal expansion of the chip 222.

The following describes a connection relationship between the circuit board components.

The second connector 225 of the first chip package structure 220 may be connected to the first connector 230 on the first circuit board 210. The second connector 225 may include a plurality of second connection interfaces 2251. The first connector 230 may include a plurality of first connection interfaces 2301. The plurality of second connection interfaces 2251 may correspond to the plurality of first connection interfaces 2301. The circuit board assembly 20 may include a plurality of first wires 331. The plurality of first wires 331 may correspond to the plurality of second connection interfaces 2251. Each second connection interface 2251 may be connected to one or more corresponding first connection interfaces 2301 through one or more corresponding first wires 331.

The sixth connector 321 of the first chip package structure 220 may be connected to the fifth connector 330 on the third circuit board 310. The sixth connector 321 may include a plurality of sixth connection interfaces 3211. The fifth connector 330 may include a plurality of fifth connection interfaces 3301. The plurality of sixth connection interfaces 3211 may correspond to the plurality of fifth connection interfaces 3301. The circuit board assembly 20 may include a plurality of third wires 333. The plurality of third wires 333 may correspond to the plurality of fifth connection interfaces 3301. Each fifth connection interface 3301 may be connected to one or more corresponding sixth connection interfaces 3211 through one or more corresponding third wires 333.

The eighth connector 430 on the fourth circuit board 410 may be connected to the seventh connector 260 on the first circuit board 210. The eighth connector 430 may include a plurality of eighth connection interfaces 4301. The seventh connector 260 may include a plurality of seventh connection interfaces 2601. The plurality of eighth connection interfaces 4301 may correspond to the plurality of seventh connection interfaces 2601. The circuit board assembly 20 may include a plurality of fourth wires 334. The plurality of fourth wires 334 may correspond to the plurality of seventh connection interfaces 2601. Each seventh connection interface 2601 may be connected to one or more corresponding eighth connection interfaces 4301 through one or more corresponding fourth wires 334.

The ninth connector 350 on the third circuit board 310 may be connected to the eleventh connector 351 on the fourth circuit board 410. The ninth connector 350 may include a plurality of ninth connection interfaces 3501. The eleventh connector 351 may include a plurality of eleventh connection interfaces 3511. The plurality of ninth connection interfaces 3501 may correspond to the plurality of eleventh connection interfaces 3511. The circuit board assembly 20 may include a plurality of fifth wires 335. The plurality of fifth wires 335 may correspond to the plurality of ninth connection interfaces 3501. Each ninth connection interface 3501 may be connected to one or more corresponding eleventh connection interfaces 3511 through one or more corresponding fifth wires 335.

The tenth connector 360 on the third circuit board 310 may be connected to the twelfth connector 361 on the fifth circuit board 510. The tenth connector 360 may include a plurality of tenth connection interfaces 3601. The twelfth connector 361 may include a plurality of twelfth connection interfaces 3611. The plurality of tenth connection interfaces 3601 may correspond to the plurality of twelfth connection interfaces 3611. The circuit board assembly 20 may include a plurality of sixth wires 336. The plurality of sixth wires 336 may correspond to the plurality of tenth connection interfaces 3601. Each tenth connection interface 3601 may be connected to one or more corresponding twelfth connection interfaces 3611 through one or more corresponding sixth wires 336.

Optionally, the first circuit board 210 may further include an electrical connection line A (not shown in FIG. 11) electrically connected between the first connector 230 and the seventh connector 260. In this way, a signal between the chip 222 and the fourth chip package structure 290 can be transmitted without passing the second chip package structure 240 on the first circuit board 210. Optionally, the third circuit board 310 may further include an electrical connection line B (not shown in FIG. 11) electrically connected between the sixth connector 321 and the fifth connector 330. In this way, a signal between the chip 222 and the fourth chip package structure 290 and a signal between the chip 222 and the fifth chip package structure 540 can be transmitted without passing the third chip package structure 340 on the third circuit board 310.

The circuit board assembly 20 shown in FIG. 11 may provide a mesh-shaped or graph-shaped module architecture. In another example, the circuit board assembly 20 may include more or fewer chip package structures and more or fewer connectors. The second chip package structure 240 and the third chip package structure 340 may be, for example, distributed preprocessing units of the first chip package structure 220. Data from the fourth chip package structure 290 or the fifth chip package structure 540 may be transmitted to the first chip package structure 220 after being preprocessed by the second chip package structure 240 and/or the third chip package structure 340. When any one of the fourth chip package structure 290 and the fifth chip package structure 540 sends a signal to the chip 222 of the first chip package structure 220, or when the chip 222 of the first chip package structure 220 is ready to send a signal to any one of the fourth chip package structure 290 and the fifth chip package structure 540, a connector and an interface through which the signal passes may be pre-determined. For example, as shown in FIG. 11, a signal sent by the fourth chip package structure 290 may be transmitted to the chip 222 through the first circuit board component 21, or may be transmitted to the chip 222 through the second circuit board component 31. A signal sent by the fifth chip package structure 540 may be transmitted to the chip 222 through the second circuit board component 31, or may be transmitted to the chip 222 through the second circuit board component 31, the third circuit board component 41, and the first circuit board component 21. An interface through which the signal is transmitted can be determined based on a signal type.

A signal sent by the chip 222 may be transmitted to the fourth chip package structure 290 and the fifth chip package structure 540 through the first circuit board component 21 and/or the second circuit board component 31. The chip 222 may determine a correct connector and/or a correct interface, so that a corresponding chip package structure can receive the signal.

In an example, the fourth chip package structure 290 and the fifth chip package structure 540 may separately manage different functions of the electronic device, and types of signals transmitted by the fourth chip package structure 290 and the fifth chip package structure 540 may be different.

An interface through which the signal is transmitted can be determined based on a signal type. For example, associated devices of signals are different, signal content is different, and signal attributes are different. For example, in the example shown in FIG. 11, the chip may determine, based on the signal type, a plurality of connection interfaces corresponding to a target chip package structure (for example, any one of the fourth chip package structure 290 and the fifth chip package structure 540).

In this embodiment of this application, the chip package structure is disposed outside the circuit board, to help reduce impact of the chip package structure on thermal deformation of the circuit board. For example, this helps reduce stress borne by the first circuit board, and improve mechanical stability of the first circuit board; and helps reduce a deformation amount of the first circuit board caused by a temperature, and helps improve flatness of the first circuit board. Coefficients of thermal expansion of a plurality of components in the chip package structure may be close as much as possible, and deformation amounts of the plurality of components in the chip package structure may be close. This helps improve connection stability between the plurality of components in the chip package structure. A coefficient of thermal expansion of a component of the chip package structure may be close to or the same as the coefficient of thermal expansion of the chip, and the coefficient of thermal expansion of the chip is generally small. Therefore, the deformation amount of the chip package structure when being heated or cold is small, and flatness of the circuit board inside the chip package structure may be high.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board assembly, comprising:
a first circuit board component, a first chip package structure, and a plurality of first wires, wherein the first chip package structure is disposed outside the first circuit board component, and the plurality of first wires are configured to transmit a signal between the first circuit board component and the first chip package structure;
the first circuit board component comprises:
a first circuit board; and
a first connector, wherein the first connector is disposed on the first circuit board and is electrically connected to the first circuit board, and the first connector comprises a plurality of first connection interfaces; and
the first chip package structure comprises:
a package substrate;
a second connector, wherein the second connector is disposed on the package substrate, the second connector comprises a plurality of second connection interfaces, the plurality of second connection interfaces correspond to the plurality of first connection interfaces of the first connector, and each second connection interface is connected to one or more corresponding first connection interfaces through one or more corresponding first wires; and
a chip, wherein the chip is disposed on the package substrate, and the chip is electrically connected to the second connector through the package substrate.

2. The circuit board assembly according to claim 1, wherein a difference between a coefficient of thermal expansion of the chip and a coefficient of thermal expansion of the package substrate is less than 5 ppm/°C.

3. The circuit board assembly according to claim 1 or 2, wherein the coefficient of thermal expansion of the chip is 2 to 7 ppm/°C, and the coefficient of thermal expansion of the package substrate is 2 to 7 ppm/°C.

4. The circuit board assembly according to any one of claims 1 to 3, wherein a difference between the coefficient of thermal expansion of the chip and a coefficient of thermal expansion of the first circuit board is greater than 5 ppm/°C.

5. The circuit board assembly according to any one of claims 1 to 4, wherein the chip is a silicon-based chip; the package substrate comprises a plurality of insulation layers and a plurality of conducting layers that are disposed in a stacked and spaced manner, one conducting layer is disposed between two adjacent insulation layers, one insulation layer is disposed between two adjacent conducting layers, and a material of the insulation layer comprises at least one of the following: ceramic, glass, and diamond.

6. The circuit board assembly according to any one of claims 1 to 5, wherein the chip comprises a plurality of first chip interfaces and a plurality of second chip interfaces, and each first chip interface is electrically connected to one or more corresponding second connection interfaces through the package substrate;
the first circuit board component further comprises:
a third connector, wherein the third connector is disposed on the first circuit board and is electrically connected to the first circuit board, and the third connector comprises a plurality of third connection interfaces;
the first chip package structure further comprises:
a fourth connector, wherein the fourth connector is disposed on the package substrate, the fourth connector comprises a plurality of fourth connection interfaces, each fourth connection interface is electrically connected to one or more corresponding second chip interfaces through the package substrate, and the plurality of fourth connection interfaces correspond to the plurality of third connection interfaces; and
the circuit board assembly further comprises:
a plurality of second wires, wherein the plurality of second wires correspond to the plurality of third connection interfaces, and each third connection interface is connected to one or more corresponding fourth connection interfaces through one or more corresponding second wires.

7. The circuit board assembly according to any one of claims 1 to 6, wherein the first circuit board component further comprises a second chip package structure, the second chip package structure is disposed on the first circuit board, and a signal between the first chip package structure and the second chip package structure is transmitted through the first circuit board, the first connector, and the plurality of first wires.

8. The circuit board assembly according to claim 7, wherein the circuit board assembly further comprises a second circuit board component and a plurality of third wires, and the plurality of third wires are configured to transmit a signal between the second circuit board component and the first chip package structure;
the second circuit board component comprises:
a third circuit board;
a fifth connector, wherein the fifth connector is disposed on the third circuit board, the fifth connector comprises a plurality of fifth connection interfaces, and the plurality of fifth connection interfaces correspond to the plurality of third wires; and
a third chip package structure, wherein the third chip package structure is disposed on the third circuit board, and the third chip package structure is electrically connected to the fifth connector through the third circuit board; and
the first chip package structure further comprises:
a sixth connector, wherein the sixth connector is disposed on the package substrate, the sixth connector is electrically connected to the chip through the package substrate, the sixth connector comprises a plurality of sixth connection interfaces, the plurality of sixth connection interfaces correspond to the plurality of fifth connection interfaces of the fifth connector, and each sixth connection interface is connected to one or more corresponding fifth connection interfaces through one or more corresponding third wires.

9. The circuit board assembly according to claim 8, wherein a function of the third chip package structure is different from a function of the second chip package structure.

10. The circuit board assembly according to any one of claims 7 to 9, wherein the second chip package structure is a preprocessing unit of the first chip package structure.

11. The circuit board assembly according to any one of claims 1 to 10, wherein the first circuit board component further comprises:
a seventh connector, wherein the seventh connector is disposed on the first circuit board, the seventh connector is electrically connected to the first connector through the first circuit board, and the seventh connector comprises a plurality of seventh connection interfaces;
the circuit board assembly further comprises a third circuit board component and a plurality of fourth wires, wherein the plurality of fourth wires are configured to transmit a signal between the third circuit board component and the first circuit board component, and the plurality of fourth wires correspond to the plurality of seventh connection interfaces; and
the third circuit board component comprises:
a fourth circuit board;
an eighth connector, wherein the eighth connector is disposed on the fourth circuit board, the eighth connector comprises a plurality of eighth connection interfaces corresponding to the plurality of seventh connection interfaces, and each eighth connection interface is connected to one or more corresponding seventh connection interfaces through one or more corresponding fourth wires; and
a fourth chip package structure, wherein the fourth chip package structure is disposed on the fourth circuit board, and the fourth chip package structure is electrically connected to the eighth connector through the fourth circuit board.

12. The circuit board assembly according to any one of claims 1 to 11, wherein the first circuit board is disposed parallel to the package substrate; and
the first circuit board and the package substrate are arranged in a direction perpendicular to the first circuit board; or
the package substrate is disposed on a plane on which the first circuit board is located.

13. The circuit board assembly according to any one of claims 1 to 12, wherein a connector and/or a connection interface through which a signal received/sent by the chip passes are/is determined by a signal type of the signal.

14. The circuit board assembly according to any one of claims 1 to 13, wherein the signal type comprises at least one of the following: an associated module, signal content, and a signal attribute.

15. The circuit board assembly according to any one of claims 1 to 14, wherein the first chip package structure is any one of the following: a central processing unit, an application processor, a modem processor, a graphics processing unit, an image signal processor, a video codec, a digital signal processor, a baseband processor, a neural network processor, a biometric feature recognition module, a memory, a power management unit, and an optical chip.

16. The circuit board assembly according to any one of claims 1 to 15, wherein the first wire is a flexible wire.

17. An electronic device, comprising a housing and the circuit board assembly according to any one of claims 1 to 16, wherein the circuit board assembly is accommodated in the housing.
